(19) Europäisches Patentamt / European Patent Office / Office européen des brevets

(11) **EP 4 239 284 A1**

(12) **EUROPEAN PATENT APPLICATION**
published in accordance with Art. 153(4) EPC

(43) Date of publication:
06.09.2023 Bulletin 2023/36

(21) Application number: 21885683.9

(22) Date of filing: 30.08.2021

(51) International Patent Classification (IPC):
*G01C 3/06* (2006.01)   *H01L 27/146* (2006.01)
*G01S 7/4863* (2020.01)   *G01S 17/894* (2020.01)

(52) Cooperative Patent Classification (CPC):
G01C 3/06; G01S 7/4863; G01S 17/894;
H01L 27/146

(86) International application number:
PCT/JP2021/031742

(87) International publication number:
WO 2022/091564 (05.05.2022 Gazette 2022/18)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: 28.10.2020 JP 2020180564

(71) Applicant: **TOPPAN INC.**
**Tokyo 110-0016 (JP)**

(72) Inventors:
• **OOKUBO, Yu**
**Tokyo 110-0016 (JP)**
• **NAKAGOME, Tomohiro**
**Tokyo 110-0016 (JP)**

(74) Representative: **Plasseraud IP**
**66, rue de la Chaussée d'Antin**
**75440 Paris Cedex 09 (FR)**

(54) **DISTANCE IMAGE CAPTURING ELEMENT AND DISTANCE IMAGE CAPTURING DEVICE**

(57)    A range imaging device includes: a semiconductor substrate; and a pixel circuit formed at a surface of the semiconductor substrate and including at least: a photoelectric conversion device configured to generate charge carriers based on light incident thereon from a space targeted for measurement; charge storages each configured to store at least some of the generated charge carriers; transfer MOS transistors (hereafter "TR") each provided on a corresponding one of transfer paths, each of the transfer MOS transistors being configured to transfer at least some of the generated charge carriers from the photoelectric conversion device to a corresponding one of the charge storages through the corresponding transfer path; and at least one charge drainage MOS transistor provided on a corresponding drainage path, the at least one charge drainage TR being configured to drain the generated charge carriers from the photoelectric conversion device through the corresponding drainage path. The photoelectric conversion device formed at the surface of the semiconductor substrate has an N-sided polygonal shape in plan view (N is an integer greater than or equal to 5). A total number of the transfer TR and the at least one charge drainage TR is N or more, and the N-sided polygonal shape of the photoelectric conversion device has, as its N sides, at least one first side at which the at least one charge drainage TR is provided, and second sides other than the at least one first side, each of the second sides being a side at which a corresponding one of the transfer TRs is provided.

FIG.1

**Description**

[Technical Field]

The present invention relates to range imaging devices and range imaging apparatuses.
The present application claims priority to Japanese Patent Application No. 2020-180564 filed October 28, 2020, the entire contents of which are incorporated herein by reference.

[Background Art]

Conventional time-of-flight (hereinafter referred to as "TOF") range imaging sensors use the known speed of light to measure the distance between the measurement device and an object based on the time of flight of light in a space (measurement space).
A TOF range imaging sensor emits a light pulse (e.g., near-infrared light or the like) to a measurement object, and uses a difference between the time at which the light pulse is emitted and the time at which the light pulse (reflected light) reflected by the object in a measurement space is returned, that is, the time of flight of light between the measurement device and the object, to measure the distance between the measurement device and the object (see, for example, Patent Literature 1).
When such a range imaging apparatus is used to accurately measure the distance to an object located at any distance, the quantity of charge carriers generated due to light reflected by the subject needs to be accurately read from pixels of the range imaging sensor by transferring the charge carriers using a plurality of gates.
In a TOF range imaging sensor, the amount of incident light is converted into charge carriers by a photoelectric conversion device, the charge carriers obtained by conversion are stored in a charge storage, and an analog voltage corresponding to the quantity of stored charge carriers is converted into a digital value by an AD converter.
The TOF range imaging sensor obtains the distance between the measurement device and an object based on an analog voltage corresponding to the quantity of charge carriers and on information from a digital value of the time of flight of light between the measurement device and the object.
In a range imaging apparatus, charge carriers generated by a photoelectric conversion device are stored in a different charge storage for each predetermined cycle, and the quantity of charge carriers stored in the respective charge storages is used to obtain a delay time from the time at which a light pulse was emitted to the time at which the light pulse reflected by a subject was returned. The range imaging apparatus uses the delay time and the speed of light to obtain the distance from the range imaging apparatus to the subject.
Thus, in order to transfer the charge carriers from the photoelectric conversion device to the charge storages, the photoelectric conversion device and the charge storages are provided with transfer gates (transistors) that transfer the charge carriers.

[Citation List]

[Patent Literature]

[PTL 1] JP 4235729 B

[Summary of Invention]

[Technical Problem]

However, the range imaging apparatus cannot perform accurate distance measurement if the transfer gates provided between the photoelectric conversion device and the charge storages have different transfer characteristics due to the layout.
That is, if there is variation in transfer characteristics of the transfer gates, even when the same quantity of charge carriers is generated by the photoelectric conversion device, different quantities of charge carriers are stored in the charge storages during the transfer of charge carriers from the transfer gates to the charge storages.
Thus, due to the variation in the transfer characteristics of the transfer gates, the transfer of the charge carriers generated by the photoelectric conversion device to the charge storages is not performed properly, leading to distance measurement with lower accuracy.
The present invention has been made in view of such circumstances, and provides a range imaging device and a range imaging apparatus in which transfer gates for transferring charge carriers from a photoelectric conversion device to charge storages have the same transfer characteristics, charge carriers generated by the photoelectric conversion device are transferred to the charge storages at the same transfer efficiency, and a distance measured from the charge carriers stored in the charge storages is obtained with higher accuracy.

[Solution to Problem]

In order to solve the problem described above, a range imaging device of the present invention includes: a semiconductor substrate; and a pixel circuit formed at a surface of the semiconductor substrate and including at least: a photoelectric conversion device configured to generate charge carriers based on light incident thereon from a space targeted for measurement; charge storages each configured to store at least some of the generated charge carriers; transfer MOS transistors each provided on a corresponding one of transfer paths, each of the transfer MOS transistors being configured to transfer at least some of the generated charge carriers from the photoelectric conversion device to a corresponding one of the charge storages through the corresponding transfer path; and at least one charge drainage MOS transistor provided on a corresponding drainage path, the at least one charge drainage MOS transistor being configured to drain the generated charge carriers from the photoelectric conversion device through the corresponding drainage path. The photoelectric conversion device formed at the surface of the semiconductor substrate has an N-sided polygonal shape (N is an integer greater than or equal to 5) in plan view; a total number of the transfer MOS transistors and the at least one charge drainage MOS transistor is N or more; and the N-sided polygonal shape of the photoelectric conversion device has, as its N sides, at least one first side at which the at least one charge drainage MOS transistor is provided, and second sides other than the at least one first side, each of the second sides being a side at which a corresponding one of the transfer MOS transistors is provided.

The range imaging device of the present invention may be configured such that each of the transfer MOS transistors is arranged perpendicular to a corresponding one of the sides of the N-sided polygonal shape, and the transfer MOS transistors are arranged symmetrically with respect to an axis that passes through the center of the N-sided polygonal shape.

The range imaging device of the present invention may be configured such that any of the sides of the N-sided polygonal shape is the at least one first side on which the at least one charge drainage MOS transistor is provided.

The range imaging device of the present invention may be configured such that the charge storages are arranged symmetrically with respect to the axis.

The range imaging device of the present invention may be configured to further include a microlens facing a surface of the pixel circuit, the surface of the pixel circuit being arranged to receive the light, the microlens having an optical axis that is perpendicular to an entrance surface of the photoelectric conversion device and passes through the center of the entrance surface, the entrance surface being arranged to receive the light.

A range imaging apparatus of the present invention includes: a light receiving unit including one of the above range imaging devices; and a distance image processing unit configured to obtain a distance from the range imaging device to a subject based on a distance image captured by the range imaging device.

[Advantageous Effects of Invention]

As described above, the present invention provides a range imaging device and a range imaging apparatus in which transfer gates for transferring charge carriers from a photoelectric conversion device to charge storages have the same transfer characteristics, charge carriers generated by the photoelectric conversion device are transferred to the charge storages at the same transfer efficiency, and a distance measured from the charge carriers stored in the charge storages is obtained with higher accuracy.

[Brief Description of Drawings]

Fig. 1 is a block diagram showing a schematic configuration of a range imaging apparatus of a first embodiment of the present invention.

Fig. 2 is a block diagram showing a schematic configuration of an image sensor (range imaging sensor 32) used in a range imaging apparatus 1 of the first embodiment of the present invention.

Fig. 3 is a circuit diagram showing an example configuration of pixel circuits 321 arranged in a light receiving region 320 of the range imaging sensor 32 (range imaging device) as a solid-state image sensor used in the range imaging apparatus 1 of the first embodiment of the present invention.

Fig. 4 is a diagram showing an example arrangement (layout pattern) of transistors of each pixel circuit 321 according to the first embodiment.

Fig. 5 is a diagram showing an example of a positional relationship between the photoelectric conversion device PD, transfer transistors G, and charge drainage transistors GD in Fig. 4, according to the first embodiment.

Fig. 6A is a diagram showing a cross-sectional structure taken along line segment A-A' of a semiconductor on which the pixel circuit 321 in Fig. 4 is provided.

Fig. 6B is a diagram illustrating the transfer of charge carriers from the photoelectric conversion device PD to the floating diffusions FD performed by the transfer transistors G.

Fig. 7A is a diagram showing a cross-sectional structure taken along a y-axis of the semiconductor on which the pixel circuit 321 in Fig. 5 is provided.

Fig. 7B is a diagram illustrating the transfer of charge carriers from the photoelectric conversion device PD performed by the charge drainage transistors GD.

Fig. 8 is a diagram showing an example arrangement (layout pattern) of transistors of each pixel circuit 321 according to a second embodiment.

Fig. 9 is a diagram showing an example of a positional relationship between the photoelectric conversion device PD, transfer transistors G, and charge drainage transistors GD in Fig. 8.

Fig. 10 is a diagram showing a positional relationship between the photoelectric conversion device PD and a microlens ML of a pixel circuit 321.

Fig. 11 is a plan view showing a lens array in a portion of the light receiving region 320 in which the plurality of pixel circuits 321 are arranged.

Fig. 12 is a cross-sectional view of the lens array of the pixel circuits 321 each provided with the microlens ML in Fig. 10.

Fig. 13 is a cross-sectional view of the lens array of the pixel circuits 321 each provided with the microlens ML in Fig. 10.

[Description of Embodiments]

<First Embodiment>

A first embodiment of the present invention will be described with reference to the drawings.

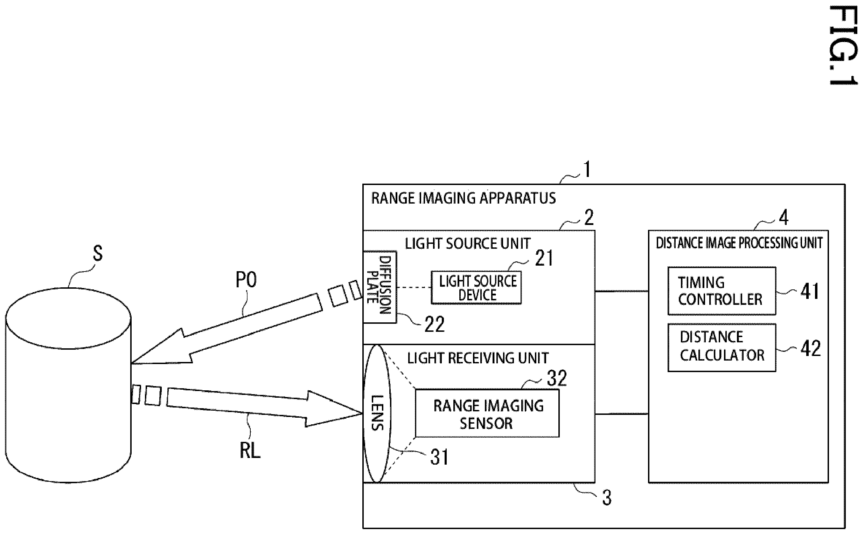

Fig. 1 is a block diagram showing a schematic configuration of a range imaging apparatus including a range imaging device of the first embodiment of the present invention. A range imaging apparatus 1 configured as shown in Fig. 1 includes a light source unit 2, a light receiving unit 3, and a distance image processing unit 4. Fig. 1 also shows a subject S as an object for which distance measurement is performed by the range imaging apparatus 1. The range imaging device may be, for example, a range imaging sensor 32 (described later) of the light receiving unit 3.

By being controlled by the distance image processing unit 4, the light source unit 2 emits a light pulse PO to a space for which image capturing is performed and in which a subject S is present as an object for which distance measurement is performed by the range imaging apparatus 1. The light source unit 2 may be, for example, a surface-emitting semiconductor laser module such as a vertical-cavity surface-emitting laser (VCSEL). The light source unit 2 includes a light source device 21 and a diffusion plate 22.

The light source device 21 is a light source that emits laser light in the near-infrared wavelength region (e.g., in a wavelength range of 850 nm to 940 nm) as the light pulse PO with which the subject S is irradiated. The light source device 21 may be, for example, a semiconductor laser light emitting device. The light source device 21 emits pulsed laser light according to control by a timing controller 41.

The diffusion plate 22 is an optical component that diffuses laser light in the near-infrared wavelength region emitted from the light source device 21 over an area in which the subject S is irradiated with the laser light. The pulsed laser light diffused by the diffusion plate 22 emerges as the light pulse PO, and the subject S is irradiated with the light pulse PO.

The light receiving unit 3 receives reflected light RL of the light pulse PO reflected by the subject S as an object for which distance measurement is performed by the range imaging apparatus 1, and outputs a pixel signal corresponding to the reflected light RL received. The light receiving unit 3 includes a lens 31 and the range imaging sensor 32 (an example of the range imaging device).

The lens 31 is an optical lens that guides the reflected light RL incident on the lens 31 to the range imaging sensor 32. The reflected light RL incident on the lens 31 emerges toward the range imaging sensor 32, and is received by (incident on) each pixel circuit provided in a light receiving region of the range imaging sensor 32.

The range imaging sensor 32 is an image sensor used in the range imaging apparatus 1. The range imaging sensor 32 includes a plurality of pixel circuits in a two-dimensional light receiving region. Pixel circuits (pixel circuits 321) of the range imaging sensor 32 each include a single photoelectric conversion device, a plurality of charge storages corresponding to the single photoelectric conversion device, and components that each distribute charge carriers to a corresponding one of the charge storages.

The range imaging sensor 32 distributes charge carriers generated by the photoelectric conversion device to each of the charge storages, according to control by the timing controller 41. Furthermore, the range imaging sensor 32 outputs a pixel signal corresponding to the quantity of charge carriers distributed to each of the charge storages. In the range imaging sensor 32, the plurality of pixel circuits are arranged in a two-dimensional matrix, and the range imaging sensor 32 outputs each pixel signal for one frame for the individual pixel circuits.

The distance image processing unit 4 controls the range imaging apparatus 1 to calculate the distance to the subject S.

The distance image processing unit 4 includes the timing controller 41 and a distance calculator 42.

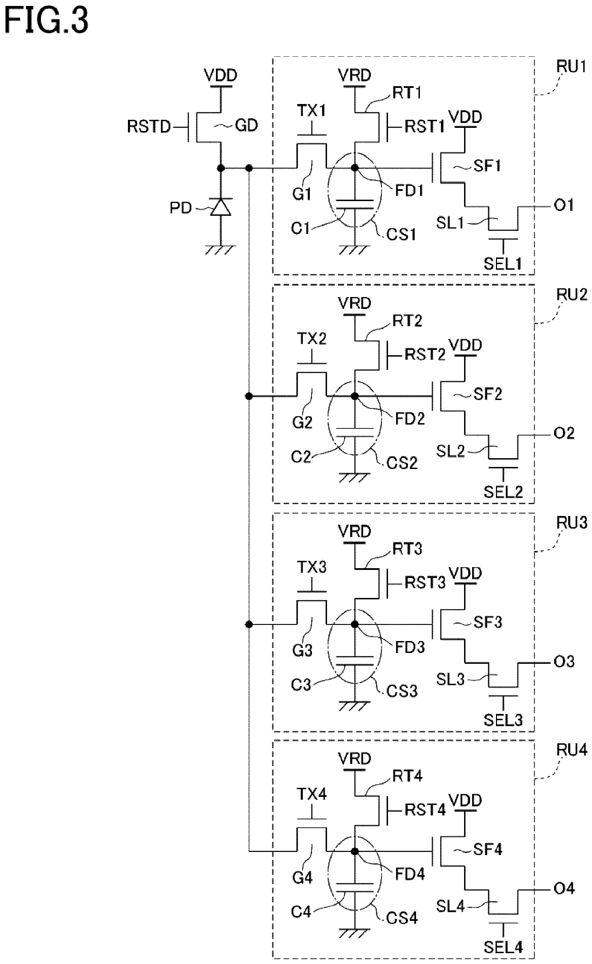

The timing controller 41 controls the timing of outputting various control signals required for distance measurement. The various control signals include, for example, a signal for controlling emission of the light pulse PO, a signal for distributing the reflected light RL to the plurality of charge storages, and a signal for controlling the number of distributions per frame. The number of distributions is the number of repetitions of the process of distributing charge carriers to charge storages CS (see Fig. 3).

The distance calculator 42 outputs distance information obtained by calculating the distance to the subject S, based on the pixel signal output from the range imaging sensor 32. The distance calculator 42 calculates a delay time Td from the time at which the light pulse PO is emitted to the time at which the reflected light RL is received, based on the quantity of charge carriers stored in the plurality of charge storages CS. The distance calculator 42 calculates the distance from the range imaging apparatus 1 to the subject S according to the calculated delay time Td.

With such a configuration, in the range imaging apparatus 1, the light pulse PO in the near-infrared wavelength region emitted from the light source unit 2 to the subject S is reflected by the subject S, and the reflected light RL is received by the light receiving unit 3, and the distance image processing unit 4 outputs distance information obtained by measuring the distance between the subject S and the range imaging apparatus 1.

Fig. 1 shows the range imaging apparatus 1 in which the distance image processing unit 4 is included; however, the distance image processing unit 4 may be a component provided outside the range imaging apparatus 1.

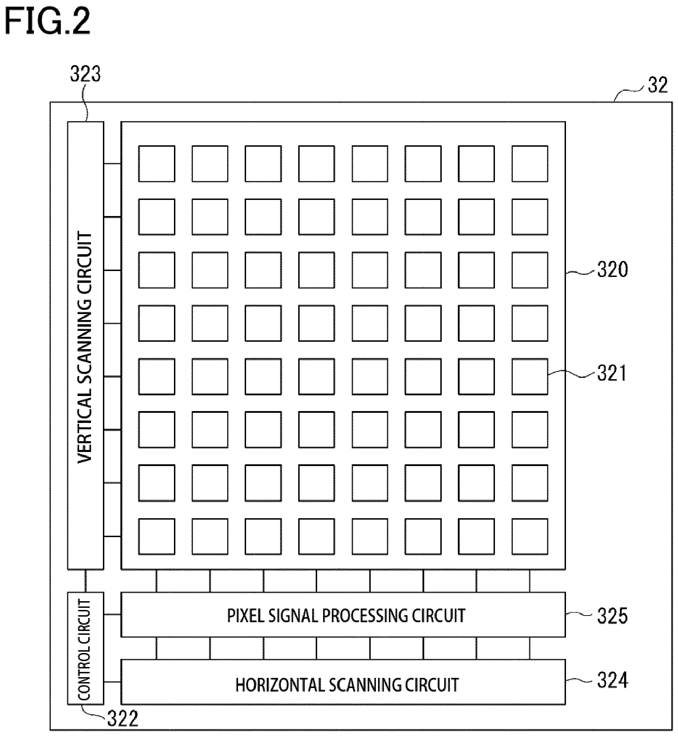

Next, a configuration of the range imaging sensor 32 used as an image sensor in the range imaging apparatus 1 will be described. Fig. 2 is a block diagram showing a schematic configuration of the image sensor (range imaging sensor 32) used in the range imaging apparatus 1 of the first embodiment of the present invention.

As shown in Fig. 2, the range imaging sensor 32 includes, for example, the light receiving region 320 in which the plurality of pixel circuits 321 are arranged, a control circuit 322, a vertical scanning circuit 323 that performs distribution operations, a horizontal scanning circuit 324, and a pixel signal processing circuit 325.

The light receiving region 320 is a region in which the plurality of pixel circuits 321 are arranged. Fig. 2 shows an example in which the pixel circuits 321 are arranged in a two-dimensional matrix with 8 rows and 8 columns. The pixel circuits 321 store charge carriers corresponding to the amount of light received. The control circuit 322 controls the operation of the components of the range imaging sensor 32, for example, according to instructions from the timing controller 41 of the distance image processing unit 4.

The vertical scanning circuit 323 is a circuit that controls, for each row, the pixel circuits 321 arranged in the light receiving region 320, according to control by the control circuit 322. The vertical scanning circuit 323 causes the pixel circuits 321 to output, to the pixel signal processing circuit 325, each voltage signal corresponding to the quantity of charge carriers stored in the individual charge storages CS of the pixel circuits 321.

The pixel signal processing circuit 325 performs predetermined signal processing (e.g., noise suppression processing, A/D conversion processing, etc.) to the voltage signals output from the pixel circuits 321 in each row to the corresponding signal line, according to control by the control circuit 322.

The horizontal scanning circuit 324 is a circuit that causes a signal output from the pixel signal processing circuit 325 to be sequentially output in a time series manner, according to control by the control circuit 322. Thus, a pixel signal corresponding to the quantity of charge carriers stored for one frame is sequentially output to the distance image processing unit 4. The following description assumes that the pixel signal processing circuit 325 performs A/D conversion processing, and the pixel signal is a digital signal.

A configuration of the pixel circuits 321 arranged in the light receiving region 320 of the range imaging sensor 32 will be described. Fig. 3 is a circuit diagram showing an example configuration of the pixel circuits 321 arranged in the light receiving region 320 of the range imaging sensor 32 (range imaging device) as a solid-state image sensor used in the range imaging apparatus 1 of the first embodiment of the present invention. The pixel circuit 321 in Fig. 3 is a configuration example including four pixel signal reading units.

The pixel circuit 321 includes a single photoelectric conversion device PD, charge drainage transistors GD (GD1 and GD2 described later), and four pixel signal reading units RU (RU1 to RU4) each of which outputs a voltage signal from the corresponding output terminal O. The pixel signal reading units RU each include a transfer transistor G, a floating diffusion FD, a charge storage capacitor C, a reset transistor RT, a source follower transistor SF, and a selection transistor SL. The floating diffusion FD and the charge storage capacitor C constitute a charge storage CS.

In the pixel circuit 321 shown in Fig. 3, the pixel signal reading unit RU1 that outputs a voltage signal from an output terminal O1 includes a transfer transistor G1 (transfer MOS transistor), a floating diffusion FD1, a charge storage capacitor C1, a reset transistor RT1, a source follower transistor SF1, and a selection transistor SL1. In the pixel signal reading unit RU1, the floating diffusion FD1 and the charge storage capacitor C1 constitute a charge storage CS1. The pixel signal reading units RU2, RU3, and RU4 also have the same configuration.

The photoelectric conversion device PD is an embedded photodiode that performs photoelectric conversion of incident light to generate charge carriers corresponding to the incident light and that stores the generated charge carriers. In the present embodiment, incident light is incident from a space to be measured.

In the pixel circuits 321, the charge carriers generated through photoelectric conversion of the incident light by the photoelectric conversion device PD are distributed to each of four charge storages CS (CS1, CS2, CS3, and CS4), and each voltage signal corresponding to the quantity of charge carriers distributed is output to the pixel signal processing circuit 325.

The configuration of the pixel circuits arranged in the range imaging sensor 32 is not limited to the configuration including the four pixel signal reading units RU (RU1, RU2, RU3, and RU4) as shown in Fig. 3. The pixel circuits may include four or more pixel signal reading units RU.

When the pixel circuits 321 of the range imaging apparatus 1 are driven, the light pulse PO is emitted for an emission time To, and after the delay time Td, the reflected light RL is received by the range imaging sensor 32. In synchronization with emission of the light pulse PO, the vertical scanning circuit 323 transfers the charge carriers generated by the photoelectric conversion device PD to the charge storages CS1, CS2, CS3, and CS4 in this order to cause the charge carriers to be stored in the charge storages.

At this time, the vertical scanning circuit 323 causes the transfer transistor G1 to be in an ON state. The transfer transistor G1 is provided on a transfer path through which charge carriers are transferred from the photoelectric conversion device PD to the charge storage CS1. Thus, charge carriers generated through photoelectric conversion by the photoelectric conversion device PD are stored in the charge storage CS1 via the transfer transistor G1. Then, the vertical scanning circuit 323 causes the transfer transistor G1 to be in an OFF state. This stops the transfer of charge carriers to the charge storage CS1. Thus, the vertical scanning circuit 323 causes charge carriers to be stored in the charge storage CS1. The same applies to the charge storages CS2, CS3, and CS4.

In this case, storage cycles are repeated in a charge storage period in which charge carriers are distributed to the charge storages CS. In the storage cycles, storage driving signals TX1, TX2, TX3, and TX4 are supplied to the transfer transistors G1, G2, G3, and G4, respectively.

Charge carriers corresponding to the incident light are transferred from the photoelectric conversion device PD to the charge storages CS1, CS2, CS3, and CS4 via the transfer transistors G1, G2, G3, and G4, respectively. A plurality of storage cycles are repeated in the charge storage period.

Thus, for the storage cycles of the charge storages CS1, CS2, CS3, and CS4 in the charge storage period, charge carriers are stored in the charge storages CS1, CS2, CS3, and CS4, respectively.

When the storage cycles of the charge storages CS1, CS2, CS3, and CS4 are repeated, after the transfer of charge carriers to the charge storage CS4 is ended, the vertical scanning circuit 323 turns on the charge drainage transistors GD1 and GD2 each provided on a discharge path through which the charge carriers are discharged from the photoelectric conversion device PD.

Thus, before the storage cycle of the charge storage CS1 is started, the charge drainage transistors GD1 and GD2 remove the charge carriers generated by the photoelectric conversion device PD after the preceding storage cycle of the charge storage CS4 (i.e., resets the photoelectric conversion device PD).

The vertical scanning circuit 323 causes, for each row (the array in the lateral direction) of the pixel circuits 321, each of all the pixel circuits 321 arranged in the light receiving region 320 to sequentially output a voltage signal to the pixel signal processing circuit 325.

The pixel signal processing circuit 325 performs signal processing such as A/D conversion processing to each of the input voltage signals, and outputs the voltage signal subjected to the signal processing to the horizontal scanning circuit 324.

The horizontal scanning circuit 324 causes the voltage signal subjected to the signal processing to be sequentially output to the distance calculator 42 in the order of the rows in the light receiving region 320.

The vertical scanning circuit 323 repeatedly performs, over one frame, the storage of charge carriers in the charge storages CS (CS1, CS2, CS3, and CS4) and the removal of the charge carriers generated through photoelectric conversion by the photoelectric conversion device PD as described above. Thus, the charge carriers corresponding to the amount of light received by the range imaging apparatus 1 during a predetermined time period are stored in each of the charge storages CS. The horizontal scanning circuit 324 outputs, to the distance calculator 42, each electrical signal corresponding to the quantity of charge carriers for one frame stored in the individual charge storages CS.

Due to the relationship between the timing at which the light pulse PO is emitted and the timing at which charge carriers are stored in each of the charge storages CS (CS1, CS2, CS3, and CS4), the quantity of charge carriers corresponding to an external light component such as background light before the emission of the light pulse PO is held in the charge storage CS1. Furthermore, the quantity of charge carriers corresponding to the reflected light RL and the external light component is distributed to the charge storages CS2, CS3, and CS4 and held therein. The distribution (distribution ratio) between the quantity of charge carriers distributed to the charge storage CS2 and the quantity of charge carriers distributed to the charge storage CS3 or the distribution ratio between the quantity of charge carriers distributed to the charge storage CS3 and the quantity of charge carriers distributed to the charge storage CS4 is a ratio corresponding to the delay time Td from the time at which the light pulse PO is emitted to the time at which the light pulse PO is incident on the range imaging apparatus 1 after being reflected by the subject S.

The distance calculator 42 uses this principle to calculate the delay time Td by the following formula (1) or (2).

$$Td = To \times (Q3 - Q1)/(Q2 + Q3 - 2 \times Q1) \ldots (1)$$

$$Td = To + To \times (Q4 - Q1)/(Q3 + Q4 - 2 \times Q1) \ldots (2)$$

Here, To represents the period during which the light pulse PO is emitted, Q1 represents the quantity of charge carriers stored in the charge storage CS1, Q2 represents the quantity of charge carriers stored in the charge storage CS2, Q3 represents the quantity of charge carriers stored in the charge storage CS3, and Q4 represents the quantity of charge carriers stored in the charge storage CS4. For example, the distance calculator 42 uses the formula (1) to calculate the delay time Td when Q4 = Q1, and uses the formula (2) to calculate the delay time Td when Q2 = Q1.

In the formula (1), charge carriers generated from the reflected light are stored in the charge storages CS2 and CS3, but are not stored in the charge storage CS4. On the other hand, in the formula (2), charge carriers generated from the reflected light are stored in the charge storages CS3 and CS4, but are not stored in the charge storage CS2.

In the formula (1) or (2), the quantity of charge carriers corresponding to the external light component of the quantity of charge carriers stored in the charge storages CS2, CS3, and CS4 is assumed to be equal to the quantity of charge carriers stored in the charge storage CS1.

The distance calculator 42 multiplies the delay time Td obtained from the formula (1) or (2) by the speed of light (speed) to calculate the round-trip distance between the range imaging sensor 32 and the subject S.

Then, the distance calculator 42 calculates 1/2 of the calculated round-trip distance to obtain the distance from the range imaging sensor 32 to the subject S.

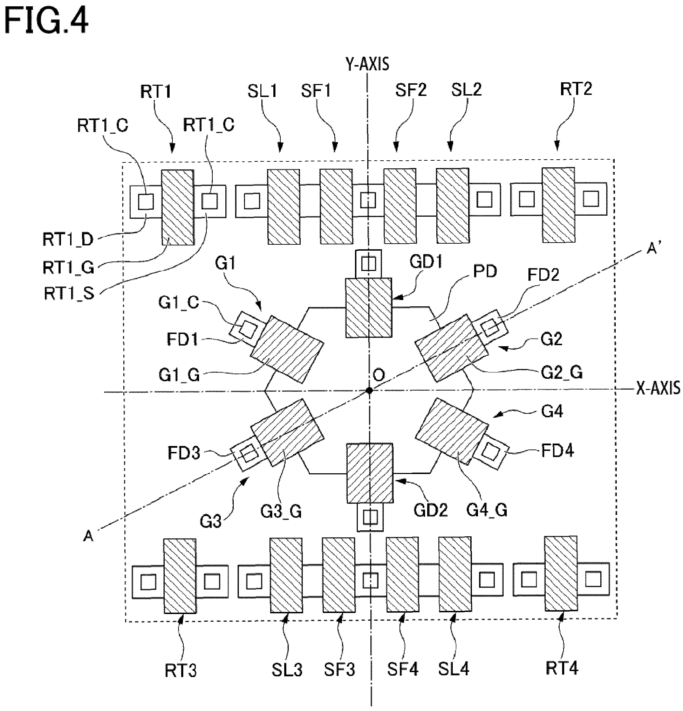

Fig. 4 is a diagram showing an example arrangement (layout pattern) of the transistors of the pixel circuits 321 according to the present embodiment.

The layout pattern in Fig. 4 is a layout pattern of the pixel circuit 321 in Fig. 3 (i.e., the pixel circuits 321 in Fig. 2).

That is, Fig. 4 shows a positional relationship of the transfer transistors G1, G2, G3, and G4 and the charge drainage transistors GD1 and GD2 (corresponding to the charge drainage transistor GD in Fig. 3) with respect to the photoelectric conversion device PD.

Fig. 4 shows an arrangement pattern of the transfer transistors G1, G2, G3, and G4, the source follower transistors SF1, SF2, SF3, and SF4, the selection transistors SL1, SL2, SL3, and SL4, the reset transistors RT1, RT2, RT3, and RT4, the charge drainage transistors GD1 and GD2, and the photoelectric conversion device PD. All the transistors described above are n-channel MOS transistors provided at a p-type semiconductor substrate.

For example, the reset transistor RT1 is composed of a drain RT1_D (n-type diffusion layer (diffusion layer of n-type impurities)), a source RT1_S (n-type diffusion layer), and a gate RT1_G at the p-type semiconductor substrate.

A contact RT1_C is a pattern indicating a contact that is provided in each of the diffusion layers, that is, the drain RT1_D (n-type diffusion layer) and the source RT1_S (n-type diffusion layer) of the reset transistor RT1, and that is connected to a wire (not shown). The transfer transistors G1, G2, G3, and G4, the source follower transistors SF1, SF2, SF3, and SF4, the selection transistors SL1 to SL4, the reset transistors RT2, RT3, and RT4, and the charge drainage transistors GD1 and GD2 also have the same configuration.

In particular, configurations of the transfer transistors G1, G2, G3, and G4 and the charge drainage transistors GD1 and GD2 will be described later.

The transfer transistor G1 is composed of the floating diffusion FD1 as a drain, a gate G1_G, and a source (n-type diffusion layer of the photoelectric conversion device PD). The floating diffusion FD1 is a diffusion layer (n-type diffusion layer) as a drain of the transfer transistor G1, and stores the charge carriers from the photoelectric conversion device PD.

A drain G1_D is connected, by a contact G1_C via a wire (not shown), to each of a gate SF1_G of the source follower transistor SF1 and the source RT1_S of the reset transistor RT1. The transfer transistors G2, G3, and G4 also have the same configuration as the transfer transistor G1.

Fig. 4 shows an arrangement of the transistors of the pixel circuits 321 at the semiconductor substrate. In Fig. 4, a wiring pattern and the charge storage capacitors (C1, C2, C3, and C4) in Fig. 3 are omitted. Thus, the charge storages CS1, CS2, CS3, and CS4 are located at the positions of the floating diffusions FD1, FD2, FD3, and FD4, respectively.

In the present embodiment, the photoelectric conversion device PD is provided at the semiconductor substrate so as to have, as an example of a polygonal shape (an N-sided polygonal shape, where N is an integer greater than or equal to 5; that is, pentagonal or more), a hexagonal shape (an example of the N-sided polygonal shape where N = 6; preferably, a shape of a regular hexagon) in plan view.

As described above, the polygonal shape in the present invention is pentagonal or more, with each side of the polygonal shape having formed thereon a transfer transistor G or a charge drainage transistor GD such that four or more transfer transistors G and one or more charge drainage transistors are provided at the sides thereof. In the present embodiment, the photoelectric conversion device PD has a hexagonal shape with a total of four transfer transistors G disposed at respective ones of four sides, and a total of two charge drainage transistors CD disposed at respective ones of the other two sides.

The transfer transistors G1, G2, G3, and G4 include the gates G1_G, G2_G, G3_G, and G4_G, respectively, as gates, the floating diffusions FD1, FD2, FD3, and FD4 (n-type diffusion layers), respectively, as drains, and the n-type diffusion layer of the photoelectric conversion device PD as a source.

In Fig. 4, the transfer transistors G1 and G4 are provided on opposite sides of the photoelectric conversion device PD having a hexagonal shape. Similarly, the transfer transistors G2 and G3 are provided on opposite sides of the photoelectric conversion device PD having a hexagonal shape.

Of the sides of the photoelectric conversion device PD having a hexagonal shape, those where the charge drainage transistors GD1 and GD2 are provided extend parallel to each other and perpendicular to a y-axis. The y-axis passes through the center O of the photoelectric conversion device PD.

The y-axis is also perpendicular to an x-axis passing through the center O of the photoelectric conversion device PD.

The floating diffusions FD1 and FD2 are arranged symmetrically with respect to the y-axis.

Similarly, the floating diffusions FD3 and FD4 are arranged symmetrically with respect to the y-axis.

In addition, the reset transistors RT1 and RT2 are arranged symmetrically with respect to the y-axis.

Similarly, the reset transistors RT3 and RT4 are arranged symmetrically with respect to the y-axis.

The source follower transistors SF1 and SF2 are arranged symmetrically with respect to the y-axis.

Similarly, the source follower transistors SF3 and SF4 are arranged symmetrically with respect to the y-axis.

In addition, the selection transistors SL1 and SL2 are arranged symmetrically with respect to the y-axis.

Similarly, the selection transistors SL3 and SL4 are arranged symmetrically with respect to the y-axis.

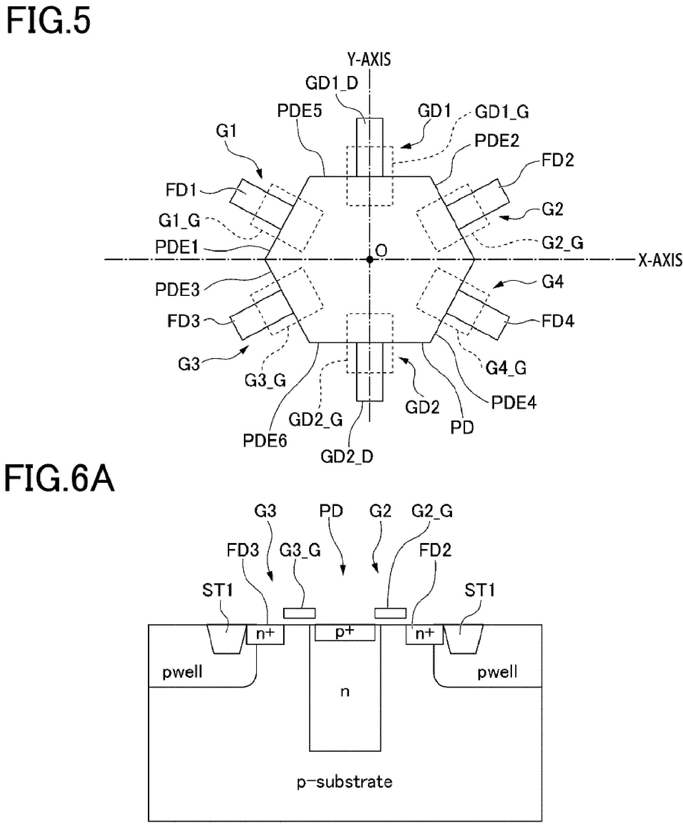

Fig. 5 is a diagram showing an example of a positional relationship between the photoelectric conversion device PD, the transfer transistors G, and the charge drainage transistors GD in Fig. 4.

Fig. 5 shows a positional relationship of the transfer transistors G1, G2, G3, and G4 and the charge drainage transistors GD1 and GD2 with respect to the photoelectric conversion device PD.

As described with reference to Fig. 4, the photoelectric conversion device PD has a hexagonal shape as a polygonal shape with its sides provided with the respective transfer transistors G1, G2, G3, and G4 and charge drainage transistors GD1 and GD2.

That is, the photoelectric conversion device PD may have a hexagonal shape as an example of a polygonal shape and sides PDE1, PDE2, PDE3, PDE4, PDE5, and PDE6.

The sides PDE1 and PDE2 are arranged symmetrically with respect to the y-axis.

Similarly, the sides PDE3 and PDE4 are arranged symmetrically with respect to the y-axis.

In contrast, the sides PDE5 and PDE6 may be arranged symmetrically with respect to the x-axis or have different configurations (e.g., the length of a side).

The transfer transistor G1 is provided at the side PDE1.

The transfer transistor G2 is provided at the side PDE2.

The transfer transistors G1 and G2 are provided at the respective sides PDE1 and PDE2 so as to be arranged symmetrically with respect to the y-axis. That is, the gates G1_G and G2_G of the respective transfer transistors G1 and G2 are arranged symmetrically with respect to the y-axis.

The transfer transistor G3 is provided at the side PDE3.

The transfer transistor G4 is provided at the side PDE4.

The transfer transistors G3 and G4 are provided at the respective sides PDE3 and PDE4 so as to be arranged symmetrically with respect to the y-axis. That is, the gates G3_G and G4_G of the respective transfer transistors G3 and G4 are arranged symmetrically with respect to the y-axis.

Moreover, the transfer transistors G1 to G4 have the same size, that is, the same channel length and channel width as each other.

The charge drainage transistors GD1 and GD2 are provided at the respective sides PDE5 and PDE6.

The size of the charge drainage transistors GD1 and GD2 may be the same as or different from that of the transfer transistors G1 to G4. The charge drainage transistors GD1 and GD2 may or may not have the same size as each other.

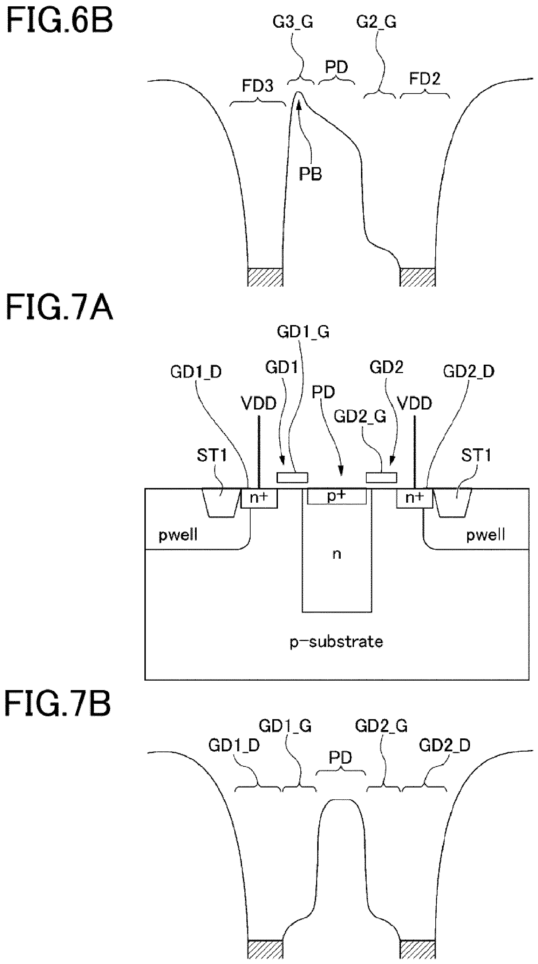

Figs. 6A and 6B are each a diagram illustrating the transfer of charge carriers from the photoelectric conversion device PD to the floating diffusions FD performed by the transfer transistors G.

Fig. 6A shows a cross-sectional structure taken along A-A' of the semiconductor on which the pixel circuit 321 in Fig. 4 is provided.

The photoelectric conversion device PD may be, for example, an embedded photodiode having a p+ diffusion layer (diffusion layer of p-type impurities) as a surface protective layer at its surface.

The transfer transistor G2 includes the n-type diffusion layer of the photoelectric conversion device PD as a source, and an n+ diffusion layer of the floating diffusion FD2 as a drain.

The n+ diffusion layer of the floating diffusion FD2 is adjacent to an STI (shallow trench isolation) and a p-well (p-type well; p-type diffusion layer) for preventing the outflow (discharge) of charge carriers (for preventing current leakage) from the n+ diffusion layer.

The transfer transistor G3 includes the n-type diffusion layer of the photoelectric conversion device PD as a source, and an n+ diffusion layer of the floating diffusion FD3 as a drain.

The n+ diffusion layer of the floating diffusion FD3 is adjacent to an STI and a p-well for preventing current leakage from the n+ diffusion layer.

In response to application of a gate voltage at an "H" level to the gate G2_G, the transfer transistor G2 transfers charge carriers (electrons) generated by the photoelectric conversion device PD to the floating diffusion FD2 as a drain. The floating diffusion FD2 stores the charge carriers transferred from the transfer transistor G2.

Similarly, in response to application of a gate voltage at the "H" level to the gate G3_G, the transfer transistor G3 transfers charge carriers (electrons) generated by the photoelectric conversion device PD to the floating diffusion FD3 as a drain. The floating diffusion FD3 stores the charge carriers transferred from the transfer transistor G3.

Fig. 6B shows a potential state in the regions of the transfer transistor G2, the photoelectric conversion device PD, and the transfer transistor G3 shown in Fig. 6A. In Fig. 6B, the horizontal axis indicates a position in the regions, and the vertical axis indicates a potential level (the potential is higher at a lower position).

Fig. 6B shows a potential state when a gate voltage at the "H" level is applied to the gate G2_G of the transfer transistor G2 and a gate voltage at an "L" level is applied to the gate G3_G of the transfer transistor G3.

The gate G3_G of the transfer transistor G3 is at the "L" level; thus, a potential barrier PB is formed in the region of the gate G3_G, and no charge carriers are transferred from the photoelectric conversion device PD to the floating diffusion FD3 as a drain of the transfer transistor G3 (no electrons flow to the drain).

On the other hand, the gate G2_G of the transfer transistor G2 is at the "H" level; thus, the potential is high (no potential barrier is formed) in the region of the gate G2_G, and charge carriers are transferred from the photoelectric conversion device PD to the floating diffusion FD2 as a drain of the transfer transistor G2 (the electrons flow to the drain).

Fig. 7A and 7B are diagrams illustrating the transfer of charge carriers from the photoelectric conversion device PD performed by the transfer transistor G1 and charge drainage transistors GD.

Fig. 7A shows a cross-sectional structure taken along the y-axis of the semiconductor on which the pixel circuit 321 in Fig. 5 is provided.

The transfer transistor G1 includes the n-type diffusion layer of the photoelectric conversion device PD as a source, and the n+ diffusion layer of the floating diffusion FD1 as a drain.

The n+ diffusion layer of the floating diffusion FD1 is adjacent to an STI and a p-well for preventing current leakage from the n+ diffusion layer.

In response to application of a gate voltage at the "H" level to the gate G1_G, the transfer transistor G1 transfers charge carriers (electrons) generated by the photoelectric conversion device PD to the floating diffusion FD1 as a drain. The floating diffusion FD1 stores the charge carriers transferred from the transfer transistor G1.

The charge drainage transistor GD1 (or GD2) includes, as a source, the n-type diffusion layer of the photoelectric conversion device PD, and, as a drain GD_D, an n+ diffusion layer connected to a power supply VDD.

The n+ diffusion layer of the drain GD2_D is adjacent to an STI and a p-well for preventing current leakage.

In response to application of a gate voltage at the "H" level to a gate GD1_G, the charge drainage transistor GD1 transfers the charge carriers (electrons) generated by the photoelectric conversion device PD to a drain GD1_D (discharges the charge carriers of the photoelectric conversion device PD to the power supply VDD).

Fig. 7B shows a potential state in the regions of the charge drainage transistor GD1, the photoelectric conversion device PD, and the charge drainage transistor GD2 shown in Fig. 7A. In Fig. 7B, the horizontal axis indicates a position in the regions, and the vertical axis indicates a potential level (the potential is higher at a lower position).

For description of a potential shape, Fig. 7B shows a state when a gate voltage at the "H" level is applied to the gate GD1_G of the charge drainage transistor GD1 and the gate GD2_G of the charge drainage transistor GD2.

The gate GD1_G of the charge drainage transistor GD1 is at the "H" level; thus, the potential is high (no potential barrier is formed) in the region of the gate GD1_G, and the charge carriers are transferred from the photoelectric conversion device PD to the drain GD1_D of the charge drainage transistor GD1 via the charge drainage transistor GD1 (the charge carriers are discharged to the power supply VDD).

Similarly, the gate GD2_G of the charge drainage transistor GD2 is at the "H" level; thus, no potential barrier is formed in the region of the gate GD2_G, and the charge carriers are transferred from the photoelectric conversion device PD to the drain GD2_D of the charge drainage transistor GD2 (the charge carriers are discharged to the power supply VDD).

In comparison between the potential states in Figs. 6B and 7B, the slope of the increase in potential (gradient of the potential) in the regions of the gates G1_G, G2_G, G3_G, and G4_G of the respective transfer transistors G1, G2, G3, and G4 and the slope of the increase in potential in the regions of the gates GD1_G and GD2_G of the respective charge drainage transistors GD 1 and GD2 are similarly steep.

This is because the transfer transistors G1, G2, G3, and G4 and the charge drainage transistors GD 1 and GD2 are provided at the same distance from the center O of the photoelectric conversion device PD.

That is, when the transfer transistors G1, G2, G3, and G4 and the charge drainage transistors GD 1 and GD2 are provided at the same distance from the center O of the photoelectric conversion device PD, the intensities of electric fields extending in the diffusion layer from the respective transfer transistors G1, G2, G3, and G4 and charge drainage transistors GD1 and GD2 toward the center O of the photoelectric conversion device PD are the same.

Due to the intensities of the electric fields in the diffusion layer being the same, the slope of the increase in potential in the regions of the gates G1_G, G2_G, G3_G, G4_G, GD1_G, and GD2_G is steep.

In the present embodiment, the transfer transistors G2 and G3 transfer charge carriers at the same transfer efficiency because they have the same shape and are located at corresponding positions.

Further, the transfer transistors G1 and G4 transfer charge carriers at the same transfer efficiency because they have the same shape and are located at corresponding positions.

If the distance from the center O of the photoelectric conversion device PD is different between the set of transfer transistors G2 and G3 and the set of transfer transistors G1 and G4, the shape of an electric field generated in response to application of a voltage to the gate is different between the set of transfer transistors G2 and G3 and the set of transfer transistors G1 and G4.

The difference in the shape of the electric field leads to a difference in a potential shape; thus, the transfer transistors G2 and G3 transfer charge carriers at a transfer efficiency different from that of the transfer transistors G1 and G4.

However, because the transfer transistors G1, G2, G3, and G4 have the same size, and the transfer efficiency of one of the set of transfer transistors G1 and G4 and the set of transfer transistors G2 and G3 is matched by the transfer efficiency of the other thereof, it is easy to cause the transfer transistors G1, G2, G3, and G4 to appear to have the same transfer efficiency by multiplying the quantity of charge carriers stored in the charge storages CS corresponding to those of the other set of the transistors by a predetermined adjustment factor.

For example, by multiplying the quantity of charge carriers transferred by the transfer transistors G2 and G3 by an adjustment factor to match the transfer efficiency of each of the transfer transistors G2 and G3 to the transfer efficiency of each of the transfer transistors G1 and G4, it is easy to cause the transfer transistors G1, G2, G3, and G4 to have the same transfer efficiency and to appear to have the same transfer characteristics.

This enables charge carriers to be transferred with the same characteristics and stored in the charge storages CS1, CS2, CS3, and CS4. Thus, the distance between a subject and the range imaging apparatus can be obtained with high accuracy by the formulas (1) and (2) using the quantity of charge carriers transferred to and stored in the charge storages CS1, CS2, CS3, and CS4.

In the present embodiment, the distance from each of the gate G1_G of the transfer transistor G1, the gate G2_G of the transfer transistor G2, the gate G3_G of the transfer transistor G3, and the gate G4_G of the transfer transistor G4 to the center O of the photoelectric conversion device PD is the same; thus, the slope of the increase in potential is the same in the gates G1_G, G2_G, G3_G, and G4_G, allowing the transfer transistors G1, G2, G3, and G4 to have the same transfer efficiency and the same transfer characteristics. This enables the transfer transistors G1, G2, G3, and G4 to highly accurately transfer charge carriers generated by the photoelectric conversion device PD to the floating diffusions FD1, FD2, FD3, and FD4, respectively.

In this case, the transfer transistors G1 and G2 and the transfer transistors G3 and G4 are arranged symmetrically with respect to the y-axis; and the transfer transistors G1 and G3 and the transfer transistors G2 and G4 are arranged symmetrically with respect to the x-axis.

Moreover, by forming a photoelectric conversion device PD having a shape of a regular hexagon in plan view, the distance from the gates G1_G, G2_G, G3_G, and G4_G of the respective transfer transistors G1, G2, G3, and G4 to the center O of the photoelectric conversion device PD can easily be the same.

That is, when the transfer transistors G1, G2, G3, and G4 respectively transfer, for example, the same quantity of charge carriers from the photoelectric conversion device PD to the floating diffusions FD1, FD2, FD3, and FD4, the same quantity of charge carriers is stored in the floating diffusions FD1, FD2, FD3, and FD4.

Therefore, in the present embodiment, charge carriers generated by the photoelectric conversion device PD can be stored in the charge storages CS 1 to CS4 at the same transfer efficiency (with the same transfer characteristics); thus, the distance between a subject and the range imaging apparatus can be obtained with high accuracy by the formulas (1) and (2) using the quantity of charge carriers stored in the charge storages CS1 to CS4.

<Second Embodiment>

A second embodiment of the present invention will be described with reference to the drawings.

The second embodiment is a range imaging device (range imaging sensor 32) of the range imaging apparatus having the same configuration as that in Fig. 2, and is configured to include pixel signal reading units RU1, RU2, RU3, and RU4 as with the configuration in Fig. 3.

Thus, the distance between a subject and the range imaging apparatus is obtained by the formulas (1) and (2) using the quantity of charge carriers stored in the charge storages CS1, CS2, CS3, and CS4, in the same manner as in the first embodiment.

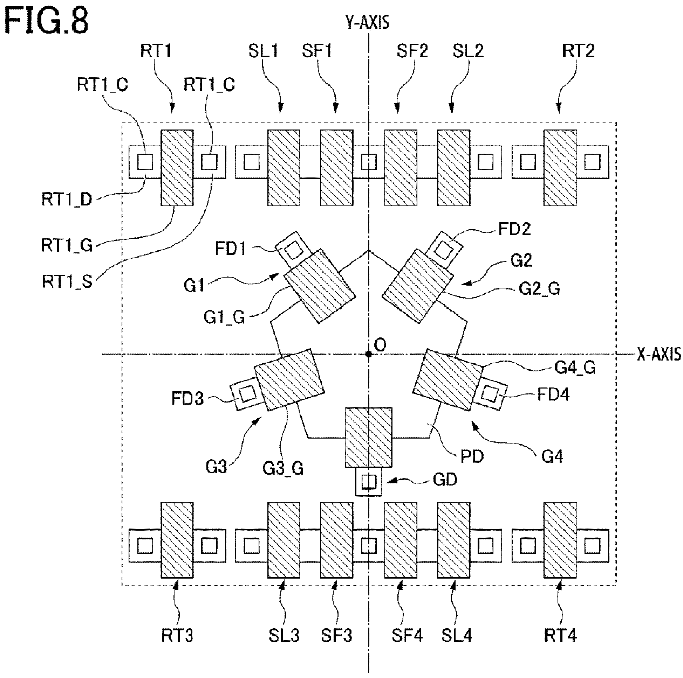

Fig. 8 is a diagram showing an example arrangement (layout pattern) of transistors of each pixel circuit 321 according to an embodiment.

The pattern in Fig. 8 is a layout pattern of the pixel circuit 321 in Fig. 3.

That is, Fig. 8 shows a positional relationship of the transfer transistors G1, G2, G3, and G4 and the charge drainage transistor GD with respect to the photoelectric conversion device PD.

The transfer transistors G1, G2, G3, and G4, the source follower transistors SF1, SF2, SF3, and SF4, the selection transistors SL1, SL2, SL3, and SL4, the reset transistors RT1, RT2, RT3, and RT4, and the charge drainage transistor GD (as with the charge drainage transistors GD of the first embodiment) are all n-channel MOS transistors provided on a p-type semiconductor substrate.

In the present embodiment, the photoelectric conversion device PD is provided at the semiconductor substrate so as to have, as an example of a polygonal shape, a pentagonal shape (an example of the N-sided polygonal shape where N = 5; preferably, a shape of a regular pentagon) in plan view.

As with the transfer transistors G1 to G3, the transfer transistor G4 includes the gate G4_G as a gate, the floating diffusion FD4 as a drain, and the n-type diffusion layer of the photoelectric conversion device PD as a source.

In Fig. 8, of the sides of the photoelectric conversion device PD having a pentagonal shape, the one where the charge drainage transistor GD is provided is parallel and extends perpendicular to a y-axis. The y-axis passes through the center O of the photoelectric conversion device PD.

The y-axis is also perpendicular to an x-axis passing through the center O of the photoelectric conversion device PD.

Fig. 8 shows an arrangement of the transistors of the pixel circuits 321 on the semiconductor substrate according to the second embodiment. In Fig. 8, a wiring pattern and the charge storage capacitors (C1 to C4) are omitted as in the first embodiment. Thus, the charge storages CS1, CS2, CS3, and CS4 are located at the positions of the floating diffusions FD1, FD2, FD3, and FD4, respectively.

The floating diffusions FD1 and FD2 are arranged symmetrically with respect to the y-axis.

Similarly, the floating diffusions FD3 and FD4 are arranged symmetrically with respect to the y-axis.

In addition, the reset transistors RT1 and RT2 are arranged symmetrically with respect to the y-axis.

Similarly, the reset transistors RT3 and RT4 are arranged symmetrically with respect to the y-axis.

The source follower transistors SF1 and SF2 are arranged symmetrically with respect to the y-axis.

Similarly, the source follower transistors SF3 and SF4 are arranged symmetrically with respect to the y-axis.

In addition, the selection transistors SL1 and SL2 are arranged symmetrically with respect to the y-axis.

Similarly, the selection transistors SL3 and SL4 are arranged symmetrically with respect to the y-axis.

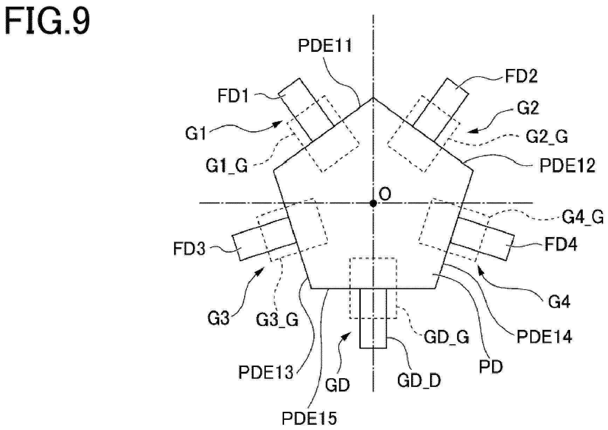

Fig. 9 is a diagram showing an example of a positional relationship between the photoelectric conversion device PD, the transfer transistors G, and the charge drainage transistor GD in Fig. 8.

The photoelectric conversion device PD may have a pentagonal shape as an example of a polygonal shape and sides PDE11, PDE12, PDE13, PDE14, and PDE15.

The sides PDE11 and PDE12 are arranged symmetrically with respect to the y-axis.

Similarly, the sides PDE13 and PDE14 are arranged symmetrically with respect to the y-axis.

The side PDE15 may have a length different from that of the sides PDE11, PDE12, PDE13, and PDE14.

The transfer transistor G1 is provided at the side PDE11.

The transfer transistor G2 is provided at the side PDE12.

The transfer transistors G1 and G2 are provided at the respective sides PDE11 and PDE12 so as to be arranged symmetrically with respect to the y-axis. That is, the gates G1_G and G2_G of the respective transfer transistors G1 and G2 are arranged symmetrically with respect to the y-axis.

The transfer transistor G3 is provided at the side PDE13.

The transfer transistor G4 is provided at the side PDE14.

The transfer transistors G3 and G4 are provided at the respective sides PDE13 and PDE14 so as to be arranged symmetrically with respect to the y-axis. That is, the gates G3_G and G4_G of the respective transfer transistors G3 and G4 are arranged symmetrically with respect to the y-axis.

Moreover, the transfer transistors G1 to G4 have the same size, that is, the same channel length and channel width as each other.

The charge drainage transistor GD is provided at the side PDE15.

The size of the charge drainage transistor GD may be the same as or different from that of the transfer transistors G1 to G4.

In the present embodiment, the transfer transistors G1 and G2 transfer charge carriers at the same transfer efficiency because they have the same size and the same shape and are located at corresponding positions.

Further, the transfer transistors G3 and G4 transfer charge carriers at the same transfer efficiency because they have the same size and the same shape and are located at corresponding positions.

If the distance from the center O of the photoelectric conversion device PD is different between the set of transfer transistors G1 and G2 and the set of transfer transistors G3 and G4, the shape of an electric field generated in response to application of a voltage to the gate is different between the set of transfer transistors G1 and G2 and the set of transfer transistors G3 and G4.

Due to the difference in the shape of the electric field, the potential shape would also be different between the sets of transfer transistors, resulting in different transfer efficiencies thereof.

However, because the transfer transistors G1 to G4 have the same size, and the transfer efficiency of one of the set of transfer transistors G1 and G2 and the set of transfer transistors G3 and G4 is matched by the transfer efficiency of the other thereof, it is easy to cause the transfer transistors G1 to G4 to appear to have the same transfer efficiency by multiplying the quantity of charge carriers stored in the charge storages CS corresponding to those of the other set of the transistors by a predetermined adjustment factor.

For example, by multiplying the quantity of charge carriers transferred by the transfer transistors G3 and G4 (the quantity of charge carriers stored in the charge storages CS) by an adjustment factor to match the transfer efficiency of each of the transfer transistors G3 and G4 to the transfer efficiency of each of the transfer transistors G1 and G2, it is easy to cause the transfer transistors G1, G2, G3, and G4 to have the same transfer efficiency and to appear to have the same transfer characteristics.

Therefore, charge carriers can be stored in the charge storages CS1 to CS4 with the same transfer characteristics; thus, the distance between a subject and the range imaging apparatus can be obtained with high accuracy by the formulas (1) and (2) using the quantity of charge carriers stored in the charge storages CS1 to CS4.

In the present embodiment, the distance from each of the gate G1_G of the transfer transistor G1, the gate G2_G of the transfer transistor G2, the gate G3_G of the transfer transistor G3, and the gate G4_G of the transfer transistor G4 to the center O of the photoelectric conversion device PD is the same; thus, the slope of the increase in potential is the same in the gates G1_G, G2_G, G3_G, and G4_G, allowing the transfer transistors G1, G2, G3, and G4 to have the same transfer efficiency and the same transfer characteristics. This enables the transfer transistors G1, G2, G3, and G4 to highly accurately transfer charge carriers generated by the photoelectric conversion device PD to the floating diffusions FD1, FD2, FD3, and FD4, respectively.

In this case, in addition to the transfer transistors G1 and G2 and the transfer transistors G3 and G$ being arranged symmetrically with respect to the y-axis, by forming a photoelectric conversion device PD having a shape of a regular pentagon in plan view, the distance from the gates G1_G, G2_G, G3_G, and G4_G of the respective transfer transistors G1, G2, G3, and G4 to the center O of the photoelectric conversion device PD can easily be the same.

That is, when the transfer transistors G1, G2, G3, and G4 respectively transfer, for example, the same quantity of charge carriers from the photoelectric conversion device PD to the floating diffusions FD1, FD2, FD3, and FD4, the same quantity of charge carriers is stored in the floating diffusions FD1, FD2, FD3, and FD4.

Therefore, in the present embodiment, charge carriers generated by the photoelectric conversion device PD can be stored in the charge storages CS1 to CS4 at the same transfer efficiency (with the same transfer characteristics); thus, the distance between a subject and the range imaging apparatus can be obtained with high accuracy by the formulas (1) and (2) using the quantity of charge carriers stored in the charge storages CS1 to CS4.

<Third Embodiment>

A third embodiment of the present invention will be described with reference to the drawings.

The third embodiment is a range imaging device (range imaging sensor 32) of the range imaging apparatus having the same configuration as that in Fig. 2, and is configured such that the pixel circuits 321 as shown in Fig. 4 are each provided with a condenser microlens.

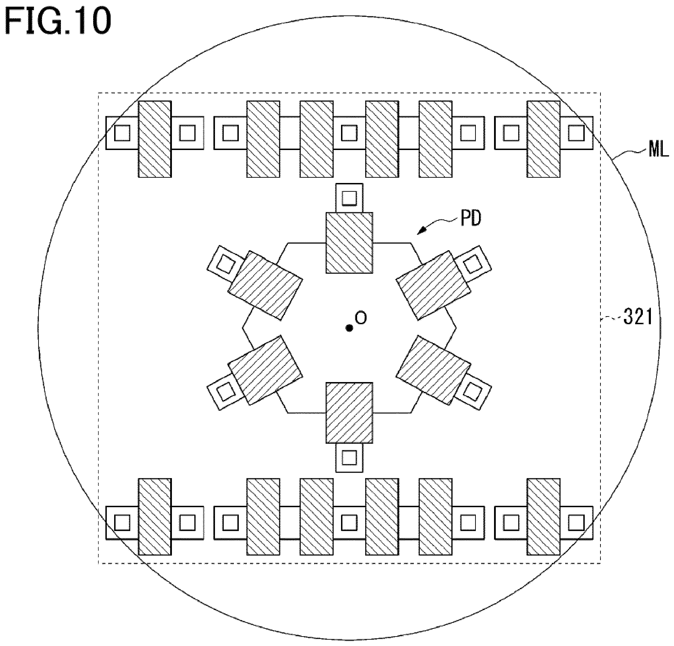

Fig. 10 is a diagram showing a positional relationship between the photoelectric conversion device PD and a microlens ML of the pixel circuits 321.

Microlenses ML are formed by thermal shaping of a predetermined resin material, and are provided to overlap in plan view with the regions in which the pixel circuits 321 are arranged.

The microlenses ML are provided in the respective pixel circuits 321 so that the optical axes of the microlenses ML (the center of the microlenses ML) overlap with the center O of the photoelectric conversion devices PD in plan view.

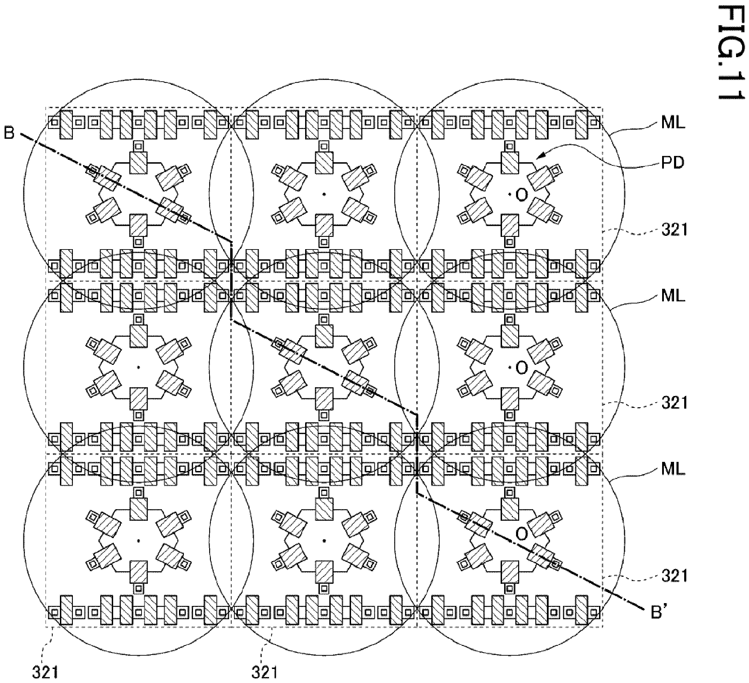

Fig. 11 is a plan view showing a lens array in a portion of the light receiving region 320 in which the plurality of pixel circuits 321 are arranged.

Fig. 11 shows a positional relationship between the pixel circuits 321 and the microlenses ML that are arranged as a lens array (microlens array) in a portion of the light receiving region 320 with a 3 × 3 matrix of pixel circuits 321.

The optical axis of each of the microlenses ML of the lens array overlaps with the center O of one of the pixel circuits 321 that overlaps with the corresponding one of the microlenses ML in plan view.

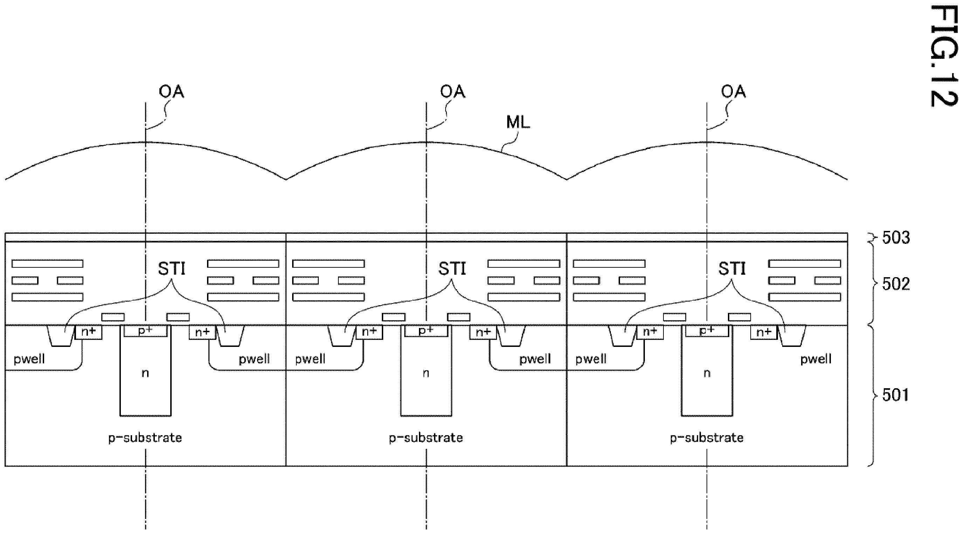

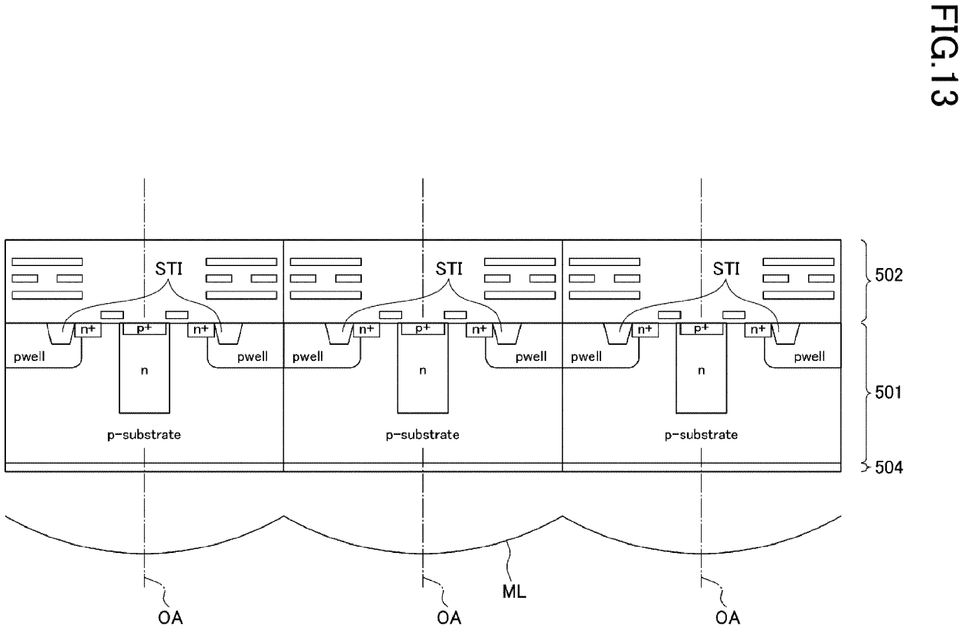

Fig. 12 is a cross-sectional view of the lens array of the pixel circuits 321 provided with the microlenses ML in Fig. 13.

Fig. 12 shows the shape of a cross section of the lens array of the pixel circuits 321 taken along line segment B-B' in Fig. 11. The range imaging sensor 32 as a range imaging device in Fig. 12 is an FSI (front side illumination) sensor in which light is incident on a surface provided with photodiodes which are the photoelectric conversion devices PD.

A wiring layer 502 that is insulated by an insulating layer is provided above a semiconductor layer 501, and a dielectric layer 503 as a passivation layer is provided above the wiring layer 502. The lens array of the microlenses ML is provided above the dielectric layer 503.

An optical axis OA of each of the microlenses ML of the microlens array is perpendicular to a surface of the photoelectric conversion device PD in the semiconductor layer 501, and passes through the center O of one of the pixel circuits 321 that overlaps with the corresponding one of the microlenses ML in plan view.

Fig. 13 is a cross-sectional view of the lens array of the pixel circuits 321 provided with the microlenses ML in Fig. 11.

Fig. 13 shows the shape of a cross section of the lens array of the pixel circuits 321 taken along line segment B-B' in Fig. 11. The range imaging sensor 32 as a range imaging device in Fig. 10 is a BSI (back side illumination) sensor in which light is incident on a back surface provided with photodiodes which are the photoelectric conversion devices PD. That is, although a front side illumination type is used as the configuration of the pixel circuits 321 in Fig. 12, as shown in Fig. 13, a back side illumination type may be used as the configuration of the pixel circuits 321.

A wiring layer 502 that is insulated by an insulating layer is provided above the semiconductor layer 501, and a dielectric layer 504 as a passivation layer is provided below the semiconductor layer 501. The lens array of the microlenses ML is provided below the dielectric layer 504.

An optical axis OA of each of the microlenses ML of the microlens array is perpendicular to a surface of the photoelectric conversion device PD in the semiconductor layer 501, and passes through the center O of one of the pixel circuits 321 that overlaps with the corresponding one of the microlenses ML in plan view.

With the configuration described above, in the present embodiment, the microlenses ML allow light incident on the pixel circuits 321 to be condensed and incident on the photoelectric conversion devices PD, and this enables efficient photoelectric conversion of the light incident on the pixel circuits 321, achieving higher sensitivity to incident light.

In the present embodiment, the arrangement of the microlenses ML with respect to the pixel circuits 321 of the first embodiment is described; however, by arranging the microlenses ML with respect to the pixel circuits 321 of the second embodiment in the same manner, it is possible to allow the pixel circuits 321 of the second embodiment to have higher sensitivity to incident light.

[Industrial Applicability]

As described above, the present invention provides a range imaging device and a range imaging apparatus in which transfer gates for transferring charge carriers from a photoelectric conversion device to charge storages have the same transfer characteristics, charge carriers generated by the photoelectric conversion device are transferred to the charge storages at the same transfer efficiency, and a distance measured from the charge carriers stored in the charge storages is obtained with higher accuracy.

[Reference Signs List]

1 ... Range imaging apparatus
2 ... Light source unit
3 ... Light receiving unit
31 ... Lens
32 ... Range imaging sensor (range imaging device)
321 ... Pixel circuit

322 ... Control circuit
323 ... Vertical scanning circuit
324 ... Horizontal scanning circuit
325 ... Pixel signal processing circuit
4 ... Distance image processing unit
41 ... Timing controller
42 ... Distance calculator
CS ... Charge storage
FD1, FD2, FD3, FD4 ... Floating diffusion
G1, G2, G3, G4 ... Transfer transistor
GD, GD1, GD2 ... Charge drainage transistor
ML ... Microlens
PD ... Photoelectric conversion device
PO ... Light pulse
RT1, RT2, RT3, RT4 ... Reset transistor
RU1, RU2, RU3, RU4 ... Pixel signal reading unit
S ... Subject
SF1, SF2, SF3, SF4 ... Source follower transistor
SL1, SL2, SL3, SL4 ... Selection transistor

**Claims**

1.  A range imaging device comprising:

    a semiconductor substrate; and
    a pixel circuit formed at a surface of the semiconductor substrate, the pixel circuit including at least:

    a photoelectric conversion device configured to generate charge carriers based on light incident thereon from a space targeted for measurement;
    charge storages each configured to store at least some of the generated charge carriers;
    transfer MOS transistors each provided on a corresponding one of transfer paths, each of the transfer MOS transistors being configured to transfer at least some of the generated charge carriers from the photoelectric conversion device to a corresponding one of the charge storages through the corresponding transfer path; and
    at least one charge drainage MOS transistor provided on a drainage path, the at least one charge drainage MOS transistor being configured to drain the generated charge carriers from the photoelectric conversion device through the drainage path,

    wherein:

    the photoelectric conversion device formed at the surface of the semiconductor substrate has an N-sided polygonal shape in plan view, and a total number of the transfer MOS transistors and the at least one charge drainage MOS transistor is N or more, N being an integer greater than or equal to 5; and
    the N-sided polygonal shape of the photoelectric conversion device has, as its N sides, at least one first side at which the at least one charge drainage MOS transistor is provided, and second sides other than the at least one first side, each of the second sides being a side at which a corresponding one of the transfer MOS transistors is provided.

2.  The range imaging device according to claim 1, wherein:

    each of the transfer MOS transistors is arranged perpendicular to a corresponding one of the sides of the N-sided polygonal shape; and
    the transfer MOS transistors are arranged symmetrically with respect to an axis that passes through a center of the N-sided polygonal shape.

3.  The range imaging device according to claim 2, wherein:
    any of the sides of the N-sided polygonal shape is the at least one first side on which the at least one charge drainage MOS transistor is provided.

4. The range imaging device according to claim 2 or 3, wherein:
the charge storages are arranged symmetrically with respect to the axis.

5. The range imaging device according to any one of claims 1 to 4, further comprising:
a microlens facing a surface of the pixel circuit, the surface of the pixel circuit being arranged to receive the light, the microlens having an optical axis that is perpendicular to an entrance surface of the photoelectric conversion device and passes through a center of the entrance surface, the entrance surface being arranged to receive the light.

6. A range imaging apparatus comprising:

a light receiving unit including the range imaging device according to any one of claims 1 to 5; and
a distance image processing unit configured to obtain a distance from the range imaging device to a subject based on a distance image captured by the range imaging device.

# FIG.1

# FIG.2

VERTICAL SCANNING CIRCUIT — 323

32

320

321

CONTROL CIRCUIT

PIXEL SIGNAL PROCESSING CIRCUIT — 325

HORIZONTAL SCANNING CIRCUIT — 324

322

# FIG.3

# FIG.4

# FIG.5

# FIG.6A

## FIG.6B

G3_G  G2_G

FD3  PD  FD2

PB

## FIG.7A

GD1_G

GD1_D  GD1  GD2  GD2_D

VDD  PD  VDD

GD2_G

ST1  ST1

n+  p+  n+

pwell  pwell

n

p-substrate

## FIG.7B

GD1_G  GD2_G

GD1_D  PD  GD2_D

EP 4 239 284 A1

# FIG.8

# FIG.9

# FIG.10

FIG.11

# FIG.12

# FIG.13

## INTERNATIONAL SEARCH REPORT

| International application No. |
|---|
| **PCT/JP2021/031742** |

**A. CLASSIFICATION OF SUBJECT MATTER**

*G01C 3/06*(2006.01)i; *H01L 27/146*(2006.01)i; *G01S 7/4863*(2020.01)i; *G01S 17/894*(2020.01)i
FI: G01S7/4863; H01L27/146 A; G01C3/06 120Q; G01S17/894

According to International Patent Classification (IPC) or to both national classification and IPC

**B. FIELDS SEARCHED**

Minimum documentation searched (classification system followed by classification symbols)

G01S7/48-7/51; G01S17/00-17/95; G01C3/06; H01L27/146;

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | WO 2020/202779 A1 (BROOKMAN TECHNOLOGY, INC.) 08 October 2020 (2020-10-08) paragraphs [0018]-[0019], [0041]-[0045], [0071], [0110]-[0114], [0124], fig. 1-2, 11, 23, 30-31 | 1-6 |
| A | JP 2019-012905 A (CANON INC.) 24 January 2019 (2019-01-24) entire text, all drawings | 1-6 |
| A | US 2019/0148448 A1 (SK HYNIX INC.) 16 May 2019 (2019-05-16) entire text, all drawings | 1-6 |
| A | US 2018/0302582 A1 (STMICROELECTRONICS (CROLLES 2) SAS) 18 October 2018 (2018-10-18) entire text, all drawings | 1-6 |

☐ Further documents are listed in the continuation of Box C.  ☑ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | "&" document member of the same patent family |
| "P" document published prior to the international filing date but later than the priority date claimed | |

| Date of the actual completion of the international search | Date of mailing of the international search report |
|---|---|
| **22 October 2021** | **09 November 2021** |

| Name and mailing address of the ISA/JP | Authorized officer |
|---|---|
| **Japan Patent Office (ISA/JP)** 3-4-3 Kasumigaseki, Chiyoda-ku, Tokyo 100-8915 Japan | |
| | Telephone No. |

Form PCT/ISA/210 (second sheet) (January 2015)

**INTERNATIONAL SEARCH REPORT**
Information on patent family members

International application No.

**PCT/JP2021/031742**

| Patent document cited in search report | | | Publication date (day/month/year) | Patent family member(s) | | | Publication date (day/month/year) |
|---|---|---|---|---|---|---|---|
| WO | 2020/202779 | A1 | 08 October 2020 | (Family: none) | | | |
| JP | 2019-012905 | A | 24 January 2019 | US | 2019/0006403 | A1 | |
| US | 2019/0148448 | A1 | 16 May 2019 | CN | 109786403 | A | |
| US | 2018/0302582 | A1 | 18 October 2018 | FR | 3065320 | A | |

Form PCT/ISA/210 (patent family annex) (January 2015)

**EP 4 239 284 A1**

REFERENCES CITED IN THE DESCRIPTION

**Patent documents cited in the description**

- JP 2020180564 A

- JP 4235729 B